(19)

**Europäisches Patentamt**

**European Patent Office**

**Office européen des brevets**

(11) **EP 4 580 350 A1**

(12) **EUROPEAN PATENT APPLICATION**

(43) Date of publication:
**02.07.2025 Bulletin 2025/27**

(21) Application number: **24223198.3**

(22) Date of filing: **24.12.2024**

(51) International Patent Classification (IPC):
*H10F 71/00* (2025.01)    *H10F 77/20* (2025.01)

(52) Cooperative Patent Classification (CPC):
**H10F 71/00; H10F 71/121; H10F 71/136; H10F 77/215**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.12.2023 IT 202300028401**

(71) Applicant: **3SUN S.r.l.**
**95121 Catania (CT) (IT)**

(72) Inventors:
- **PASSARELLA, Bianca**
**95121 Catania (IT)**
- **GERARDI, Cosimo**
**95121 Catania (IT)**
- **RAGONESI, Antonino**
**95121 Catania (IT)**
- **DI LORENZO, Paolo**
**95121 Catania (IT)**
- **DI MATTEO, Alfredo**
**95121 Catania (IT)**

(74) Representative: **Studio Torta S.p.A.**
**Via Viotti, 9**
**10121 Torino (IT)**

(54) **FLEXIBLY WORKABLE PHOTOVOLTAIC CELL AND MANUFACTURING METHOD THEREOF**

(57) Photovoltaic cell (1) including: a photovoltaic conversion region (2); and a first electrode structure (4) and a second electrode structure (6) each comprising a plurality of respective grids (10) separated from one another and arranged in succession along a first direction (Y). Pairs of adjacent grids delimit separation cavities (20) having elongated shapes along a second direction (X). The photovoltaic conversion region (2) has a dimension along the first direction (Y) equal to L and the separation cavities (20) comprise a first set (21) of a first number C and a second set (22) of a second number C', with C'>C and (C'+1)≠n(C+1). The separation cavities of the first set (21) are separated, if C>1, by a distance equal to L/(C+1) and the separation cavities of the second set (22) are separated by a distance equal to L/(C'+1). The photovoltaic cell is configured to be cut alternatively along the separation cavities of the first set (21) into a number C+1 of first portions (30), or along the separation cavities of the second set (22) into a number C'+1 of second portions (40).

Fig. 2

EP 4 580 350 A1

**Description**

<u>Cross reference to related patent Applications</u>

This patent application claims priority from Italian patent application no. 102023000028401 filed on December 29, 2023, the content of which is incorporated herein by reference.

<u>Technical field</u>

The present invention refers to a photovoltaic cell that can be flexibly processed and to the relative manufacturing method.

<u>Background</u>

A photovoltaic cell (or simply "cell") is a device capable of converting solar energy into electrical energy by exploiting the photoelectric effect at one or more junctions of regions of semiconductor material. A cell typically comprises a conversion layer, which houses such junctions, which is coated on opposite faces with conductive films (formed by the so-called TCO - "Transparent Conductive Oxide") and which is configured to receive solar radiation.

The generated charge carriers are collected by conductive structures which are formed, for example through screen printing techniques, in contact on the conductive films. The conductive structures are metal grids comprising first electrodes (called "fingers") extending along a first direction and second electrodes (called "bus bars") extending along a second direction transverse to the first one; furthermore, the metal grids form the electrical terminals of the cell through which the photogenerated current can flow.

A photovoltaic module (or simply "module") houses a plurality of cells arranged and connected to each other so as to obtain, at the outlet of the module, predetermined electrical characteristics. Nowadays, the increasing spread of modules is combined with a demand for ever-improved electrical performance, mainly in terms of conversion efficiency and maximum extractable power. In order to follow such a trend, there has been an increase in the dimensions of the individual cells (reaching, for example, 210 mm full-square cells); in fact, such an increase allows the maximum voltage at the ends of the cell to be kept constant and the extractable current to be increased, in proportion to the area of the cell.

The demand for cells with greater power, however, may clash in practice with problems of increased resistive losses and of operating temperatures of the cells themselves - mainly due to the greater circulating current - with the risk of compromising, in terms of electrical performance, the beneficial effects of a greater dimension. To overcome these possible problems, it is customary in the photovoltaic sector to cut the cells along one dimension, for example into two or three parts, before assembling them into modules, obtaining portions of cells (sub-cells) typically of identical dimensions.

Among the various fields in which the cells find application, the market can be considered as typically divided into two application macrosectors: an industrial one (defined as "Utility Scale", US), referred, for example, to applications of modules in solar plants; and a residential one (defined as "Distributed Generation", DG), referred, for example, to domestic rooftop installations. It is typically preferred to allocate the cells with greater efficiency to the US applications, while in the DG applications the focus is more directed, for aesthetic reasons, on the colour of the cells.

It is common practice among cell manufacturers to cut the cells intended for US applications into two portions, whilst the cells intended for DG applications into three portions. The cutting of the cells is typically performed after the formation of the conductive structures. For example, the cutting can be performed using a laser cut parallel to the direction of extension of the "fingers" electrodes. It therefore follows that the conductive structures are printed according to layouts that include cutting regions. In view of the above, these cutting regions are different depending on the type of application for which the cells are intended.

In the production chains, the use of dedicated printers and masks for the creation of different layouts may not be advantageous in economic and throughput terms. Furthermore, since the application destination of the cells is typically chosen a priori, a possible consequence is that, following the characterization measures of the voltage-current curves and/or of the colour, the manufacturer is forced to discard cells, or even entire batches, as they do not comply with the desired specifications for the type of application.

<u>Summary</u>

It is therefore an object of the present invention to provide a solution which at least in part overcomes the disadvantages and limitations of the prior art.

According to the present invention, a photovoltaic cell and the relative manufacturing method are presented, as defined in the appended claims.

Brief description of the Figures

To better understand the present invention preferred embodiments thereof will be now described, for merely exemplary and non-limiting purposes, with reference to the appended drawings, wherein:

- Figure 1 shows schematically a cross-section of a portion of a photovoltaic cell according to an embodiment of the present invention;
- Figure 2 shows schematically in top plan view the photovoltaic cell of 1;
- Figure 3a shows schematically in top plan view portions of the photovoltaic cell of Figure 2 resulting from a cut of the photovoltaic cell;
- Figure 3b shows schematically in top plan view portions of the photovoltaic cell of Figure 2 resulting from a different cut of the photovoltaic cell;
- Figure 4 shows schematically in top plan view a photovoltaic cell according to a different embodiment of the present invention;
- Figure 5a shows schematically in top plan view portions of the photovoltaic cell of Figure 4 resulting from a cut of the photovoltaic cell; and
- Figure 5b shows schematically in top plan view portions of the photovoltaic cell of Figure 4 resulting from a different cut of the photovoltaic cell.

Description of embodiments

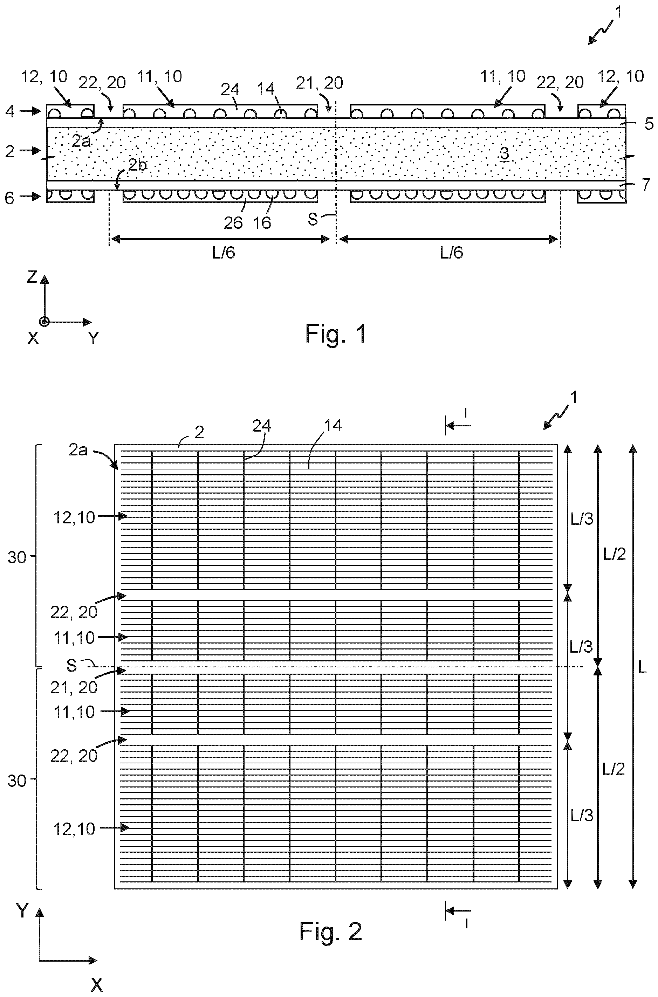

With reference to Figures 1 and 2, a photovoltaic cell (or simply "cell") according to a first embodiment is indicated as a whole with number 1 and comprises a conversion layer 2, a first conductive structure 4 and a second conductive structure 6. The conversion layer 2 is provided with a front surface 2a and with a rear surface 2b, which are opposite to each other. The first and the second conductive structure 4, 6 are formed respectively on the front surface 2a and on the rear surface 2b of the conversion layer 2.

The conversion layer 2 comprises in detail a semiconductive area 3, a first conductive film 5 and a second conductive film 7 coating the semiconductive area 3 on opposite faces. With reference in particular to Figure 1, the semiconductive area 3 is interposed between the first and the second conductive film 5, 7 and houses a multilayer structure (not shown separately) of materials (e.g. crystalline silicon) with different and/or opposite doping, forming at least one junction. The semiconductive area 3 represents the active area of the cell, where the photons are absorbed at the junction, generating charge carriers that give rise to the photogenerated current. The first and the second conductive film 5, 7 are thin layers which have at the same time anti-reflective properties for incident radiation and conductive properties (so-called TCO), and which are deposited (for example, through PVD - "Physical Vapour Deposition") on opposite faces of the semiconductive area 3. The first and the second conductive film 5, 7 are delimited in the cell 1 respectively by the front surface 2a and by the rear surface 2b of the conversion layer 2. The conversion layer 2 is therefore a wafer that is formed according to known techniques of the semiconductor sector and that is diced with dimensions according to cell 1.

Considering a reference system of orthogonal axes X, Y, Z, the cell 1 has a planar shape in planes parallel to the plane XY and can be for example square, with side L (with dimensions for example equal to $210 \times 210$ mm); furthermore, Figure 1 shows a cross-section of the cell 1 in a plane parallel to the plane YZ.

The charge carriers generated along the entire dimension of the semiconductive area 3 of the conversion layer 2 are collected by the first and by second conductive structure 4, 6. In detail, with reference to Figure 2, the first and the second conductive structure 4, 6 are metal grids that are formed respectively in contact with the front surface 2a and the rear surface 2b of the conversion layer 2 and form the electrical terminals of the cell through which the photogenerated current can flow.

In the non-limiting example of bifacial photovoltaic cells, both the front surface 2a and the rear surface 2b of the conversion layer 2 may receive light radiation; for example, the front surface 2a may be the side of the cell 1 exposed to direct solar radiation, while the rear surface 2b may be the side of the cell 1 that receives diffused radiation (indicated with "albedo") from the ground or from other surfaces in proximity to the photovoltaic module that integrates the cell 1. That said, the first and the second conductive structure 4, 6 can be different from each other based on the needs of exposure and thus of maximizing the incident light radiation; the metal grid of the first conductive structure 4 has, for example, wider weft than the metal grid of the second conductive structure 6. Figure 2 shows the cell 1 in its entire dimension, parallel to the plane XY (the cell 1 is for example square), by looking in particular at the side of the cell 1 relative to the front surface 2a.

The first and the second conductive structure 4, 6 are respectively formed in contact on the first and the second conductive film 5, 7 through screen printing techniques and are made of a conductive material, for example a metal, even more in detail silver, copper or metal alloys prevalently with silver and/or copper.

The first and the second conductive structure 4, 6 comprise respective pluralities of first electrodes (known as "fingers"), respectively indicated with 14 and 16, of elongated shape parallel to the axis X and to each other laterally and periodically spaced along the axis Y so as to leave the conversion layer 2 substantially exposed to the incident radiation. As anticipated, the first electrodes 14 of the first conductive structure 4 can be offset along the axis Y with a greater pitch than the first electrodes 16 of the second conductive structure 6. In first approximation, the first electrodes 14, 16 run, parallel to the axis X, along the entire dimension of the cell 1.

The first and the second conductive structure 4, 6 also comprise respective pluralities of second electrodes (known as "busbars"), respectively indicated with 24, 26 and having an elongated shape parallel to the axis Y. In detail, with reference for the sake of brevity only to the second electrodes 24 of the first conductive structure 4, to the first electrodes 14 and to the front surface 2a (the same considerations apply to the second electrodes 26 of the second conductive structure 6, to the first electrodes 16 and to the rear surface 2b), each second electrode 24 of the first conductive structure 4 is arranged on the front surface 2a, in direct contact, and is interposed between corresponding pairs of portions of first electrodes 14; in particular, the second electrodes 24 are laterally offset along the axis X. Each first electrode 14 is therefore formed by a plurality of corresponding portions, separated from one another, as shown in Figure 2; furthermore, each portion of first electrode 14 contacts, at the ends thereof, two corresponding consecutive second electrodes 24.

Each second electrode 24 of the first conductive structure 4 may be vertically aligned, parallel to the axis Z, with a corresponding second electrode 26 of the second conductive structure 6. The second electrodes 24, 26 perform a function of collecting the charge carriers conveyed by the respective portions of first electrodes 14, 16. For practical purposes, the first and the second conductive structure 4, 6 may be formed starting from different screen prints so as to provide, as mentioned, a desired weft width.

Still with reference to Figure 2, each of the first and the second conductive structure 4, 6 of the cell 1 is divided into respective grids 10 separated from one another and geometrically offset along the axis Y so as to expose respective portions of the conversion layer 2. In detail, the grids 10 are portions of the respective first and second conductive structure 4, 6 and as such have the respective arrangements of the first electrodes 14, 16 and of the second electrodes 24, 26 described above. Even more in detail, the grids 10 are separated along the axis Y so that the second electrodes 24, 26 of the cell 1 are interrupted, each grid 10 thus comprising a plurality of second electrode portions 24, 26 offset along the axis X. Thus, corresponding second electrode portions 24, 26 of adjacent grids 10 are aligned parallel to the axis Y and face each other exposing respective end portions. In the cell 1, the grids 10 of the first conductive structure 4 correspond in terms of position to corresponding grids 10 of the second conductive structure 6; consequently, particular grids of the respective conductive structures are identified below using the same reference numerals; moreover, the considerations made for the grids of the first conductive structure 4 also apply to the corresponding grids of the second conductive structure 6, unless otherwise specified.

With reference also to Figure 1 and taking into consideration for the sake of brevity only the first conductive structure 4, adjacent grids 10 laterally delimit respective separation regions 20, hereinafter referred to as separation cavities. In particular, the separation cavities 20 are delimited for the entire length of the cell 1, parallel to the axis X, by facing pairs of first electrodes portions 14 and by facing pairs of end parts of second electrodes portions 24, where present, belonging to respective adjacent grids 10. The separation cavities 20 are further delimited at the bottom by corresponding portions of the front surface 2a of the conversion layer 2. The separation cavities 20 therefore have an elongated shape parallel to the axis X, are offset from each other along the axis Y, separate respective adjacent grids 10 and face onto corresponding portions of the conductive film 5.

In practice, the separation cavities 20 can be made by employing prefixed printing masks of the first and the second conductive structure 4, 6, which provide cutting regions, i.e. interruptions, along a dimension of the photovoltaic cell (in the cell 1, along the axis Y). As anticipated, the separation cavities 20 of the first conductive structure 4 are vertically aligned with respective separation cavities 20 of the second conductive structure 6, so that the cell 1 can be cut, parallel to the axis Z, into respective portions. The number of portions into which the cell 1 can be cut depends on the particular geometric arrangement of the separation cavities 20 in the cell 1.

In the non-limiting embodiment of Figures 1 and 2, the cell 1 has a number of separation cavities 20 equal to three and a number of grids 10 equal to four. In detail, the cell 1 is symmetrical with respect to a plane S of symmetry, parallel to the plane XZ and passing centrally with respect to the cell 1, so as to divide the cell 1 into two equal portions 30 (or "half portions") equal in dimension, along the axis Y, to L/2. Even more in detail, the cell 1 comprises a first separation cavity 21 extending along the axis X in a position that is central to the cell 1, the first separation cavity 21 also being divided by the plane S into two equivalent parts.

The two portions 30 of the cell 1 each further comprise a second separation cavity 22. The second separation cavities 22 are symmetrically positioned at a distance equal to L/6 from the plane S, each in its own portion 30 of the cell 1 (the geometric distances considered here are measured between the longitudinal axes of the separation cavities 20). The separation cavities 20 of the cell 1 are for example rectangular in shape, in top view, have a width along the axis Y equal to 1 mm $\pm$ 0.5 mm and extend for the entire dimension of the cell 1 along the axis X, while the first electrodes 14, 16 are offset from each other, for example, by a distance equal to about 0.7 mm.

In consideration of the foregoing, in each of the two portions 30 of the cell 1 the first conductive structure 4 is divided into two grids 10 and, more in particular, into a first grid 11 and into a second grid 12 separated from one another by a respective second separation cavity 22. Each first grid 11, moreover, extends between the first separation cavity 21 and the respective second separation cavity 22, in its own portion 30 of the cell 1. Each second grid 12 therefore has a dimension, along the axis Y, in first approximation equal to L/3. In addition, the part of the cell 1 comprised between the respective second separation cavities 22 of the portions 30 has a dimension, along the axis Y, also equal to L/3 and comprises the respective first grids 11 and the first separation cavity 21 (in other words, the second separation cavities 22 are offset along the axis Y by a distance equal to L/3).

As anticipated, the separation cavities 20 of the cell 1 are configured to be cutting regions of the cell 1 itself. The cell 1 can in fact be cut according to two alternative cutting configurations, to give rise to: two first portions of photovoltaic cell, mutually equivalent in size, each having a dimension along the axis Y equal to L/2 and therefore corresponding to the portions 30 of the cell 1 (and indicated with the same reference number), when the cut is performed along the first separation cavity 21 (first cutting configuration); or three second portions 40 of photovoltaic cell, mutually equivalent in size and each having a dimension along the axis Y equal to L/3, when the cut is performed along the two second separation cavities 22 (second cutting configuration).

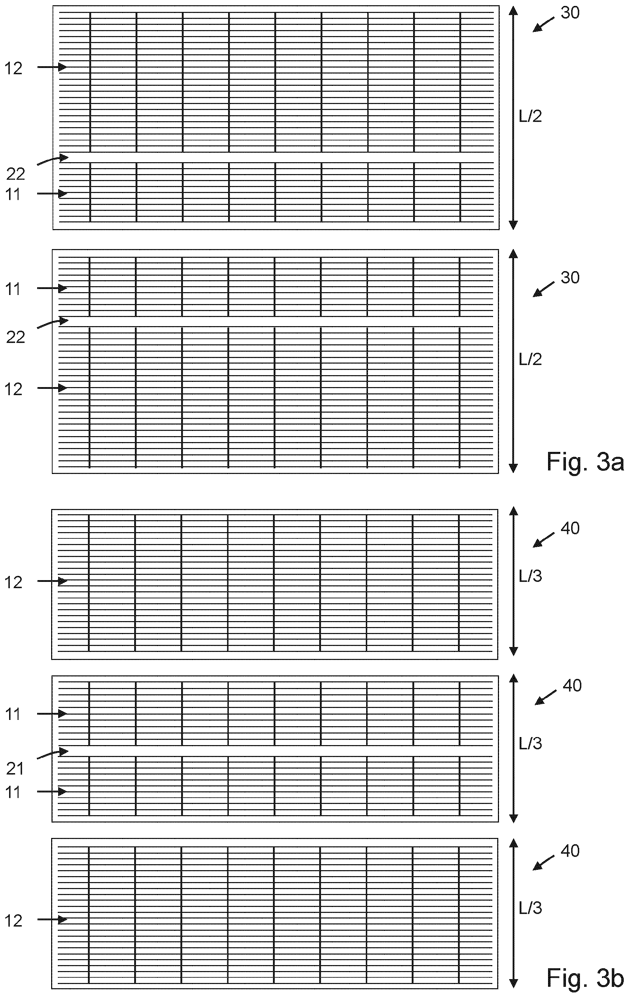

With reference to Figure 3a, the two first portions 30 of the cell 1 are shown close to each other following the relative cutting. In detail and as described above, each first portion 30 comprises a respective first grid 11 and a respective second grid 12 of the first conductive structure 4 separated from one another by the respective second separation cavity 22.

With reference to Figure 3b, the three second portions 40 of the cell 1 are shown close to each other following the relative cutting. In detail, the three second portions 40 comprise a central second portion 40 and two lateral second portions 40. The central second portion 40 comprises the first separation cavity 21 of the cell 1 and the two first grids 11 of the first conductive structure 4. The two lateral second portions 40 instead each comprise a respective second grid 12 of the first conductive structure 4.

In use, the photovoltaic cell exhibits increased flexibility when choosing the application destination of the respective portions into which it is cut. In particular, the conductive structures on the same side of the photovoltaic cell are printed starting from a single printing layout and using the same printing mask, as well as a single screen printing machine, regardless of the number of portions into which the photovoltaic cell is cut. In this way, it is possible to cut the photovoltaic cell as a function of the outcome of the characterization measures of the voltage-current curves and/or of the colour, and therefore to decide its application destination a posteriori based on a classification in terms of electrical and colour performance obtained in the particular batch of the production process. It is therefore also possible to maximize the production throughput of the equipment that realizes the metallizations of the conductive structures as well as of the entire process, minimizing the waste due to parametric nonconformities related to a specific application.

In practice, the photovoltaic cells such as the cell 1 of Figure 2 are an intermediate product in the manufacturing process of a photovoltaic module. In particular, following the cutting of photovoltaic cells such as the cell 1 according to one between the first cutting configuration or the second cutting configuration, the resulting respective first portions 30 or second portions 40 (hereinafter referred to for the sake of brevity as "portions" of cells) are mechanically arranged and electrically connected in order to form a string of the photovoltaic module. In detail, it is customary in the sector to flank cells (here, portions of cells) parallel to the direction of extension of the second electrodes (bus bars) and to make electrical interconnections using specific "wire" or "ribbon" connectors of conductive material that connect opposite faces of consecutive portions of cells to each other. The connectors are coupled to the faces of the portions of cells in positions corresponding to the second electrodes, typically using special machinery known as stringers and for example by gluing or welding. Advantageously, the electrical interconnections between consecutive portions of cells improve the electrical continuity between distinct grids of same portions of cells (for example, between the first grid 11 and the second grid 12 of a first portion 30 of cell or between first grids 11 of a central second portion 40 of cell); for example, with reference to Figure 3a or 3b, portions of second electrodes belonging to adjacent grids and which are aligned along the axis Y, on the same portion of cell, are interconnected by the same connector, which also overlies the corresponding separation cavity.

In general, the photovoltaic cell may comprise conductive structures made with a different printing layout, so as to comprise a number of separation cavities and a number of grids different from the cell 1 of Figure 2.

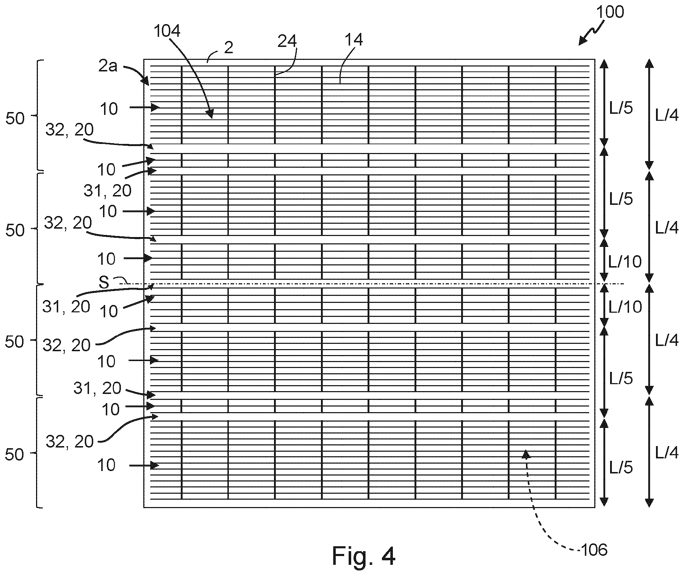

For example, Figure 4 shows a cell 100 comprising first and second conductive structure 104, 106, each comprising eight respective grids 10 and seven respective separation cavities 20.

In detail, with reference for the sake of brevity only to the separation cavities 20 delimited by the first conductive structure 104 (but the same considerations also apply to the separation cavities delimited by the second conductive structure 106), the cell 100 comprises three first separation cavities 31, offset from each other along the axis Y by a distance equal to L/4, and four second separation cavities 32, offset from each other along the axis Y by a distance equal to L/5. Even more in detail, a first separation cavity 31 is positioned centrally to the cell 100 so as to divide it into two half equivalent portions. By virtue of the symmetry of the cell 100 with respect to the plane S, therefore, the remaining two first separation cavities 31 are positioned symmetrically at a distance equal to L/4 from the plane S, each in a respective half portion of the cell 100. Each half portion is then further separated from a respective first separation cavity 31 into two parts having the same dimension along the axis Y, to which reference is made below with first portions 50.

Each first portion 50 further comprises a respective second separation cavity 32, the second separation cavities 32 being positioned in the cell 1 symmetrically with respect to the plane S. In particular, the two respective second separation cavities 32 of respective adjacent first portions 50 belonging to different half portions of the cell 100 are each positioned at a distance equal to L/10 from the plane S.

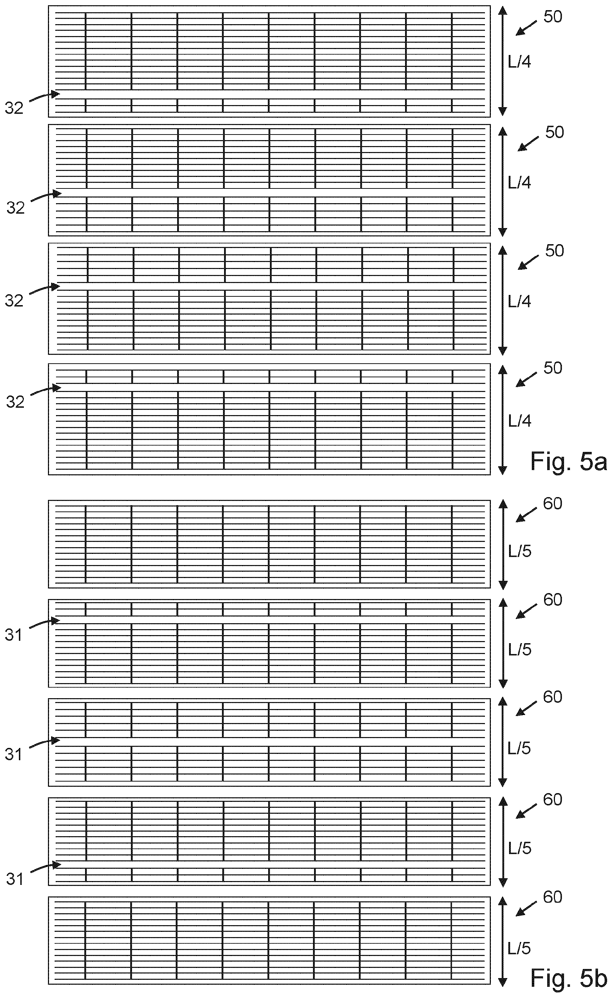

The grids 10 of the cell 100 extend between and delimit the separation cavities 20 according to the geometry just described and shown in Figure 4. The cell 100 is therefore arranged to be cut according to at least two alternative cutting configurations, to give rise to (refer to Figures 5a and 5b): four first portions 50 of photovoltaic cell mutually equivalent in size and each having a dimension along the axis Y equal to L/4, when the cutting is performed along the first separation cavities 31 (first cutting configuration); or five second portions 60 of photovoltaic cell, mutually equivalent in size and each having a dimension along the axis Y equal to L/5, when the cutting is performed along the second separation cavities 32 (second cutting configuration).

Of the five second portions 60 resulting from the cutting of the cell 100 according to the second cutting configuration, two lateral second portions 60 are devoid of separation cavities 20 while three central second portions 60 each comprise a first separation cavity 31, according to the geometry described above. In addition, the cell 100 inherently provides for the possibility of being cut also according to a third cutting configuration, when cutting is performed along only the first separation cavity 31 central to the cell 100.

The present photovoltaic cell can generally be cut according to at least two alternative cutting configurations: a first cutting configuration provides that the cell is cut into N portions, which have dimension along the axis Y equal to L/N, with $N \geq 2$; a second cutting configuration provides that the cell is cut into N' portions, which have dimension along the axis Y equal to L/N', with N' > N and N' $\neq$ nN (n, positive integer).

In detail, the positioning of the separation cavities 20 in the specific printing layout of the conductive structures of the photovoltaic cell can be mathematically generalized as follows. Considering a generic coordinate yi in order to express the distance, along the axis Y, of a generic separation cavity 20 from the plane S and also considering, for the sake of brevity, a single half portion of the cell (for example the half portion along the positive direction of the axis Y, but the same considerations apply to the respective symmetrical half portion) and the only first conductive structure, indicated with D a generic number of portions into which the cell must be cut, it applies that:

$$y_i = \begin{cases} \displaystyle\sum_{i=0}^{\left\lfloor \frac{D}{2} \right\rfloor - 1} \left( \frac{1}{2} + i \right) \frac{L}{D} & , \ if \ D \ is \ odd \\[2em] \displaystyle\sum_{i=0}^{\left\lfloor \frac{D}{2} \right\rfloor - 1} i \frac{L}{D} & , \ if \ D \ is \ even \end{cases}$$

wherein $y_i$ is referred to the longitudinal axis of the corresponding separation cavity 20, and wherein:

- D, positive integer, must be replaced individually with N and N' (taking into account what is specified above);
- index i is a positive integer;
- the integer part function, $\lfloor x \rfloor$ , returns, starting from a decimal number, the previous integer; and
- the coordinate $y_0$ represents the coordinate of the separation cavity 20 closest to the plane S (for example, $y_0 = 0$ indicates the separation cavity 20 that divides the cell into two half portions and that is divided by the plane S into two equivalent parts).

In the cell 1 of Figure 2, N = 2 and N' = 3, while in the cell 100 of Figure 4, N = 4 and N' = 5. The indication "first separation cavities" therefore refers to the separation cavities 20, belonging to a first set, which are configured to be cutting regions of the (first) cutting configuration of the photovoltaic cell in N first portions, while the indication "second separation cavities" refers to the separation cavities 20, belonging to a second set, which are configured to be cutting regions of the (second) cutting configuration of the photovoltaic cell in N' second portions. The N first portions and the N' second portions each comprising at least one grid 10 of the conductive structures.

It is also possible to define in a general way the number of separation cavities 20 of each set. In particular, being C and C' respectively the number of separation cavities 20 of the first and the second set, with C' > C and (C' + 1) $\neq$ n(C + 1), one has that C = N - 1 and C' = N' - 1.

Summarizing, for each of the first and the second conductive structure, the photovoltaic cell comprises at least two distinct sets of separation cavities 20, the separation cavities 20 of each set being arranged according to the laws set forth above; moreover, in each set, if D > 2 (i.e., C > 1), pairs of adjacent separation cavities 20 are the same distance apart, along the axis Y, said distance being alternatively equal to L/N or L/N'. Each set of separation cavities 20 makes accessible corresponding sets of portions of respective front surface 2a and rear surface 2b of the conversion layer 2 during cell cutting operations according to respective cutting configurations.

Finally, it is clear that modifications and variations may be made to what has been described and illustrated herein without thereby departing from the scope of the present invention, as defined in the attached claims.

For example, the following technologies can be adopted indifferently for the photovoltaic cell of the present invention: amorphous and crystalline silicon hetero Junction Technology (HJT) cells; monocrystalline silicon cells; polycrystalline silicon cells; multilayer cells comprising multiple different materials including, for example, silicon and perovskite; BSF ("Back Surface Field") cells; PERC ("Passivated Emitter and Rear Contact") cells; PERT ("Passivated Emitter and Rear Totally Diffused") cells; TOPCon ("Tunnel Oxide Passivated Contact") cells; IBC ("Interdigitated Back-Contacted") cells.

Instead of the second electrodes of each grid of each conductive structure described above, the photovoltaic cell may comprise pairs of corresponding second electrodes facing each other along the axis X and extending, in a parallel manner, along the axis Y.

## Claims

1.  A photovoltaic cell (1; 100) comprising:

    - a photovoltaic conversion region (2), delimited by a front surface (2a) and by a rear surface (2b) and symmetrical with respect to a plane (S) orthogonal to the front surface (2a) and to the rear surface (2b); and
    - a first electrode structure (4; 104) and a second electrode structure (6; 106), formed of conductor material and extending respectively on the front surface (2a) and on the rear surface (2b);

    the first electrode structure (4; 104) and the second electrode structure (6; 106) each comprising a plurality of respective grids (10), which are separated from one another and are arranged in succession along a first direction (Y), so that pairs of adjacent grids laterally delimit corresponding separation cavities (20) having elongated shapes along a second direction (X) transverse to the first direction (Y);
    and wherein the photovoltaic conversion region (2) has a dimension along the first direction (Y) equal to L; and wherein the separation cavities (20) delimited by the first electrode structure (4; 104) face onto corresponding portions of the front surface (2a), so that said portions of the front surface are accessible during cutting operations of the photovoltaic cell, and comprise a first set (21; 31) of a first number C of separation cavities and a second set (22; 32) of a second number C' of separation cavities, with C'>C and (C'+1)≠n(C+1), with n being a positive integer,
    the separation cavities of the first set (21; 31) being arranged symmetrically with respect to the plane (S) and being furthermore arranged, along the first direction (Y), so that, if C>1, adjacent separation cavities of the first set are separated by a distance equal to L/(C+1), the separation cavities of the second set (22; 32) being arranged symmetrically to the plane (S) and being furthermore arranged, along the first direction (Y), so that adjacent separation cavities of the second set are separated by a distance equal to L/(C'+1);
    and wherein each separation cavity (20) delimited by the second electrode structure (6; 106) is aligned, parallel to the plane (S), with a corresponding separation cavity (20) delimited by the first electrode structure (4; 104), so that the photovoltaic cell is configured to be cut alternatively along the separation cavities of the first set (21; 31) into a number C+1 of first portions (30; 50), or along the separation cavities of the second set (22; 32) into a number C'+1 of second portions (40; 60).

2.  The photovoltaic cell (1; 100) according to claim 1, wherein the first portions (30; 50) have the same dimension along the first direction (Y), and wherein the second portions (40; 60) have the same dimension along the first direction (Y).

3.  The photovoltaic cell (1; 100) according to claim 1 or 2, comprising two half portions symmetrical to each other with respect to the plane (S), and wherein, in each half portion, the separation cavities of the first set (21; 31) arranged on said half portion are arranged, with respect to the plane (S) and along the first direction (Y), in respective coordinates $y_i$, wherein:

$$y_i = \begin{cases} \sum_{i=0}^{\left\lceil \frac{N}{2} \right\rceil - 1} \left( \frac{1}{2} + i \right) \frac{L}{N} & , \quad \textit{if N is odd} \\ \sum_{i=0}^{\left\lceil \frac{N}{2} \right\rceil - 1} i \frac{L}{N} & , \quad \textit{if N is even} \end{cases}$$

with i being a positive integer and N=C+1; and wherein the separation cavities of the second set (22; 32) arranged on said half portion are arranged in respective coordinates y'i, wherein:

$$y'_i = \begin{cases} \sum_{i=0}^{\left\lceil \frac{N'}{2} \right\rceil - 1} \left( \frac{1}{2} + i \right) \frac{L}{N'} & , \quad \textit{if N' is odd} \\ \sum_{i=0}^{\left\lceil \frac{N'}{2} \right\rceil - 1} i \frac{L}{N'} & , \quad \textit{if N' is even} \end{cases}$$

with N'=C'+1.

4.  The photovoltaic cell (1) according to any one of the preceding claims, wherein C=1 and C'=2 and wherein the separation cavity (21) of the first set of the first electrode structure (4) divides the photovoltaic cell into two first portions (30) equal and symmetrical with respect to the plane (S), each first portion (30) further comprising a respective separation cavity (22) of the second set of the first electrode structure (4), which has a distance from the plane (S) equal to L/6.

5.  The photovoltaic cell (1; 100) according to any one of the preceding claims, wherein the grids (10) each comprise a plurality of first electrodes (14), having elongated shape parallel to the second direction (X) and offset along the first direction (Y), and a plurality of second electrodes (24), having elongated shape parallel to the first direction (Y) and offset along the second direction (X), each second electrode being interposed between corresponding pairs of portions of first electrodes;
    and wherein each separation cavity (20) is laterally delimited by a corresponding pair of facing first electrodes, belonging respectively to the grids of the corresponding pair of adjacent grids.

6.  A manufacturing method of a photovoltaic cell (1; 100) comprising:

    - forming a photovoltaic conversion region (2), delimited by a front surface (2a) and a rear surface (2b) and symmetrical with respect to a plane (S); and
    - forming a first electrode structure (4; 104) and a second electrode structure (6; 106) of conductor material on the front surface (2a) and on the rear surface (2b) respectively;

    the first electrode structure (4; 104) and the second electrode structure (6; 106) each comprising a plurality of respective grids (10), which are separated from one another and are arranged in succession along a first direction (Y), so that pairs of adjacent grids laterally delimit corresponding separation cavities (20) having elongated shapes along a second direction (X) transverse to the first direction (Y);
    and wherein the photovoltaic conversion region (2) has a dimension along the first direction (Y) equal to L;
    and wherein the separation cavities (20) delimited by the first electrode structure (4; 104) face onto corresponding portions of the front surface (2a), so that said portions of the front surface are accessible during cutting operations of the photovoltaic cell, and comprise a first set (21; 31) of a first number C of separation cavities and a second set (22; 32) of a second number C' of separation cavities, with C'>C and (C'+1)≠n(C+1), with n being a positive integer,
    the separation cavities of the first set (21; 31) being arranged symmetrically with respect to the plane (S) and furthermore being arranged, along the first direction (Y), so that if C>1, adjacent separation cavities of the first set are separated by a distance equal to L/(C+1), the separation cavities of the second set (22; 32) being arranged symmetrically with respect to the plane (S) and being furthermore arranged, along the first direction (Y), so that adjacent separation cavities of the second set are separated by a distance equal to L/(C'+1); and wherein each separation cavity (20) delimited by the second electrode structure (6; 106) is aligned, parallel to the plane (S), with a corresponding separation cavity (20) delimited by the first electrode structure (4; 104), so that the photovoltaic cell is configured to be cut alternatively along the separation cavities of the first set (21; 31) into a number C+1 of first portions (30; 50), or along the separation cavities of the second set (22; 32) into a number C'+1 of second portions (40; 60).

7. The manufacturing method according to claim 6, wherein the first portions (30; 50) have the same dimension along the first direction (Y), and wherein the second portions (40; 60) have the same dimension along the first direction (Y).

8. The manufacturing method according to claim 6 or 7, wherein C=1 and C'=2 and wherein the separation cavity (21) of the first set of the first electrode structure (4) divides the photovoltaic cell into two first portions (30) equal and symmetrical with respect to the plane (S), each first portion (30) furthermore comprising a respective separation cavity (22) of the second set of the first electrode structure (4), which has a distance from the plane (S) equal to L/6.

9. The manufacturing method according to any one of the claims from 6 to 8, wherein the plurality of grids (10) of the first electrode structure (4; 104) is formed through the same first screen print,
and wherein the plurality of grids (10) of the second electrode structure (6; 106) is formed through the same second screen print.

10. The manufacturing method of a photovoltaic module comprising:

    - cutting at least a photovoltaic cell (1; 100) according to any one of the claims from 1 to 5 alternatively along the separation cavities of the first set (21; 31) into a number C+1 of first portions (30; 50), or along the separation cavities of the second set (22; 32) into a number C'+1 of second portions (40; 60); and
    - electrically coupling to one another the first portions or the second portions.

Fig. 1

Fig. 2

Fig. 3a

Fig. 3b

Fig. 4

Fig. 5a

Fig. 5b

Europäisches
Patentamt

European
Patent Office

Office européen
des brevets

# EUROPEAN SEARCH REPORT

**Application Number**

EP 24 22 3198

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/296171 A1 (CHANG JAEWON [KR] ET AL) 26 September 2019 (2019-09-26) | 1-9 | INV. H10F71/00 H10F77/20 |
| A | * figures 5-7 * | 10 | |
| A | EP 4 207 317 A1 (SOLAREDGE TECHNOLOGIES LTD [IL]) 5 July 2023 (2023-07-05) * the whole document * | 1-10 | |
| A | AU 2018 279 035 B2 (MAXEON SOLAR PTE LTD [SG]) 11 July 2019 (2019-07-11) * the whole document * | 1-10 | |

**TECHNICAL FIELDS SEARCHED (IPC)**

H01L
H10F

The present search report has been drawn up for all claims

| Place of search | Date of completion of the search | Examiner |
|---|---|---|
| Berlin | 15 May 2025 | Le Meur, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 580 350 A1**

**ANNEX TO THE EUROPEAN SEARCH REPORT
ON EUROPEAN PATENT APPLICATION NO.**

EP 24 22 3198

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2025

| Patent document cited in search report | Publication date | Patent family member(s) | | Publication date |
|---|---|---|---|---|
| US 2019296171 A1 | 26-09-2019 | KR 20190112457 | A | 07-10-2019 |
| | | US 2019296171 | A1 | 26-09-2019 |
| | | WO 2019190063 | A1 | 03-10-2019 |
| EP 4207317 A1 | 05-07-2023 | AU 2022291670 | A1 | 20-07-2023 |
| | | CN 116387388 | A | 04-07-2023 |
| | | EP 4207317 | A1 | 05-07-2023 |
| | | JP 2023099330 | A | 12-07-2023 |
| | | US 2024072189 | A1 | 29-02-2024 |
| AU 2018279035 B2 | 11-07-2019 | AU 2015267239 | A1 | 24-11-2016 |
| | | AU 2018279029 | A1 | 17-01-2019 |
| | | AU 2018279033 | A1 | 17-01-2019 |
| | | AU 2018279035 | A1 | 17-01-2019 |
| | | AU 2019101205 | A4 | 07-11-2019 |
| | | AU 2019101206 | A4 | 07-11-2019 |
| | | AU 2019101207 | A4 | 07-11-2019 |
| | | AU 2019222952 | A1 | 05-12-2019 |
| | | AU 2021261854 | A1 | 02-12-2021 |
| | | AU 2023251472 | A1 | 09-11-2023 |
| | | CN 108305904 | A | 20-07-2018 |
| | | CN 109346538 | A | 15-02-2019 |
| | | CN 109768095 | A | 17-05-2019 |
| | | CN 114582986 | A | 03-06-2022 |
| | | JP 1661435 | S | 08-06-2020 |
| | | JP 1676513 | S | 12-01-2021 |
| | | JP 6554703 | B2 | 07-08-2019 |
| | | JP 7369746 | B2 | 26-10-2023 |
| | | JP 2017517145 | A | 22-06-2017 |
| | | JP 2022000916 | A | 04-01-2022 |
| | | JP 2023171674 | A | 01-12-2023 |
| | | KR 20170057177 | A | 24-05-2017 |
| | | KR 20210013311 | A | 03-02-2021 |
| | | KR 20220028170 | A | 08-03-2022 |
| | | MX 377666 | B | 10-03-2025 |
| | | SA 516380384 | B1 | 17-07-2021 |
| | | SA 520420601 | B1 | 16-11-2022 |
| | | SA 520420653 | B1 | 02-01-2023 |

EPO FORM P0459

For more details about this annex : see Official Journal of the European Patent Office, No. 12/82

15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IT 102023000028401